(19) **Europäisches Patentamt**
**European Patent Office**
**Office européen des brevets**

(11) Publication number: **0 160 439 B1**

## EUROPEAN PATENT SPECIFICATION

(45) Date of publication of patent specification: **12.06.91**

(51) Int. Cl.⁵: **H05K 3/02, H05K 3/38, H05K 1/03, B32B 15/08, H05K 3/44**

(21) Application number: **85302553.4**

(22) Date of filing: **11.04.85**

(54) **Improved printed circuit board.**

(30) Priority: **24.04.84 JP 83308/84**

(43) Date of publication of application:
**06.11.85 Bulletin 85/45**

(45) Publication of the grant of the patent:
**12.06.91 Bulletin 91/24**

(84) Designated Contracting States:
**DE FR GB**

(56) References cited:
**EP-A- 0 090 696**
**DE-A- 2 945 191**
**US-A- 3 136 680**
**US-A- 4 236 952**
**US-A- 4 335 180**

**Bulletin 600 (August 1980) of Keene Corporation (Chase-Foster Division)**

(73) Proprietor: **JUNKOSHA CO. LTD.**
**25-25, Miyasaka 2-chome**
**Setagaya-ku Tokyo 156(JP)**

(72) Inventor: **Suzuki, Hirosuke**
**21-8 Kotesashi-machi 4-chome**
**Tokorozawa-shi Saitama(JP)**

(74) Representative: **Klunker . Schmitt-Nilson .**
**Hirsch et al**
**Winzererstrasse 106**
**W-8000 München 40(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a printed circuit board. In particular the invention relates to a printed circuit board to be used for transmission of electrical signals at high frequencies, such as microwaves and millimeter waves.

Conventional printed circuit boards for these high frequencies include a printed circuit board consisting of a layer of polytetrafluoroethylene in which glass fibres are mixed, and copper cladding on one or both faces thereof. Examples of such printed circuit boards are Di-Clad 522 and 527 described in Bulletin 600 (August 1980) from the Keene Corporation (Chase-Foster Division). When such a printed circuit board is used at 10 GHz, the signal transmission delay time is about 5.2 ns/m, and the dielectric loss is as great as 0.002, which is undesirable for certain applications. EP-0090696 also discloses a printed circuit board comprising a substrate layer of PTFE and a metallic coating layer on at least one face.

In order that the manufacturing and handling of a printed circuit board and the forming or mounting of a circuit on the printed circuit board can be easily accomplished, it is preferable that a printed circuit board has both sufficiently high firmness and still retains some flexibility. The materials suitably used to meet these requirements include a film of polyimide resin, a film of polyamide resin and a film of polyester. The electrical insulating characteristics of all of these films are excellent. For example, the dielectric loss of a printed circuit board using a film of polyimide resin is 0.04, a printed circuit board using a film of polyamide resin 0.05, and a printed circuit board using a film of polyester resin 0.045 (all of these values determined at 1 megahertz). However, the frequency dependence of printed circuit boards using these films is high, so that they usually cannot be used for transmission at high frequencies.

An object of the present invention is to provide a printed circuit board having excellent high-frequency transmission properties. Preferably such printed circuit board is flexible.

According to the present invention there is provided a printed circuit board comprising a layer of polytetrafluoroethylene (PTFE) firmly bonded to and in laminar contact with at least one layer of electrically conducting metal, characterised in that the PTFE layer is of expanded porous PTFE.

The metal layer can be catalytically plated onto a surface of the expanded, porous PTFE or it may be a metal foil bonded to the expanded, porous PTFE layer with a bonding agent. The bonding agent can be tetrafluoroethylene-perfluoroalkyl-vinyl ether copolymer (PFA) or tetrafluoroethylene-hexafluoropropylene copolymer (FEP). The layer of expanded, porous PTFE may be a cloth woven from fibers of expanded, porous PTFE. The layer of expanded, porous PTFE may contain a filler such as titanium dioxide powder or aluminum oxide powder. The layer of expanded, porous PTFE may have a plurality of through holes. The layer of expanded, porous PTFE may be a composite of a plurality of layers of expanded, porous PTFE having different specific gravities. The expanded, porous PTFE may have a layer of solid, non-porous plastic material bonded to one side thereof, the solid layer consisting of solid, non-porous PTFE, polyimide resin, polyamide resin or polyester resin.

The invention will now be particularly described, by way of example, with reference to the accompanying drawings in which:-

Figure 1 is a schematic diagram, partly in cross-section of one embodiment of this invention showing a board to be used in the manufacture of a printed circuit board.

Figures 2-10 are cross-sectional views of alternative embodiments of boards in accordance with this invention, and

Figure 11 is a top plan view of the printed circuit board of the embodiment of Figure 9 provided with film carrier holes.

A printed circuit board for use in the 10 GHz signal transmission range is provided comprising a layer of expanded, porous PTFE having a layer of electrical signal transmitting metal firmly bonded to one side thereof and preferably having a layer of solid plastic such as polyimide, polyamide or polyester bonded to the other side. Unwanted metal is removed to provide the desired circuitry.

It has been determined, by the present inventor, that when a layer of dielectric material consisting of expanded, porous PTFE is provided along a metallic conductor circuit in a printed board, the transmission properties of the printed circuit board can be improved, and that, when preferably a thin film of polyimide resin is provided on this layer of expanded, porous PTFE, a flexible printed circuit board having excellent transmission properties and a high firmness can be formed.

To achieve the objects of the invention, a printed circuit board is provided which is formed by bonding a layer of expanded, porous PTFE along a metallic conductor circuit. Because the printed circuit board is formed in this manner, the following effects can be obtained: (1) the signal transmission delay time is considerably short, i.e. 4.1-3.6 ns/m; (2) the dielectric loss factor is as small as not more than $10^{-4}$; (3) because the specific permittivity is small, the thickness of the conductor can be increased to a level which is higher than that in a conventional printed circuit board, and, because the dielectric loss is also small, the signal is attenuated only to a small extent; (4) because a porous material is used, there is only a very slight possibility that the dielectric will expand and contract with temperature changes, and, accordingly, the stability of the printed circuit board is high; (5) because a porous material is used, a coolant, such as helium gas can enter the interior of the dielectric, so that the dielectric-cooling effect can be increased; (6) because the physically and chemically stable PTFE material is used, a highly reliable product can be obtained; and (7) the material in use has a small dielectric loss, and is suitable as a dielectric for transmission of waves in the millimeter wave length range. Therefore, the material can be connected to a dielectric line directly from an end surface or a cut surface of the printed circuit board. This enables the transmission line to be greatly simplified.

With the construction described above, the thermal conductivity, bonding strength and dimensional stability of the printed circuit board can be improved by mixing a metallic oxide, such as titanium oxide or alumina, in a layer of expanded, porous PTFE. Also, the performance of the printed circuit board can be improved by providing a plurality of through holes in the layer of expanded, porous PTFE and thereby further reducing the specific permittivity thereof.

In this construction, the layer of expanded, porous PTFE may consist of a cloth of fiber of the same resin, or a lamination of layers of expanded, porous PTFE of different specific gravities, or a layer of expanded, porous PTFE having on at least one surface thereof a layer of solid PTFE.

Expanded, porous PTFE can be made, in either film or fiber form, as taught in U.S. Patent 3,953,566.

A hard core layer can be bonded to the layer of expanded, porous PTFE so as to increase the capability of retaining the form thereof. The porous resin layer can be provided thereon with a film of a dimensionally stable material, such as a film of polyimide resin, a film of polyamide resin, or a film of polyester resin, or an enamel layer so as to render the resultant printed circuit board both sufficiently firm and flexible. The layer of porous resin can also be provided with film carrier holes therein so as to carry out the manufacturing of printed circuit boards and the connecting of circuit elements efficiently.

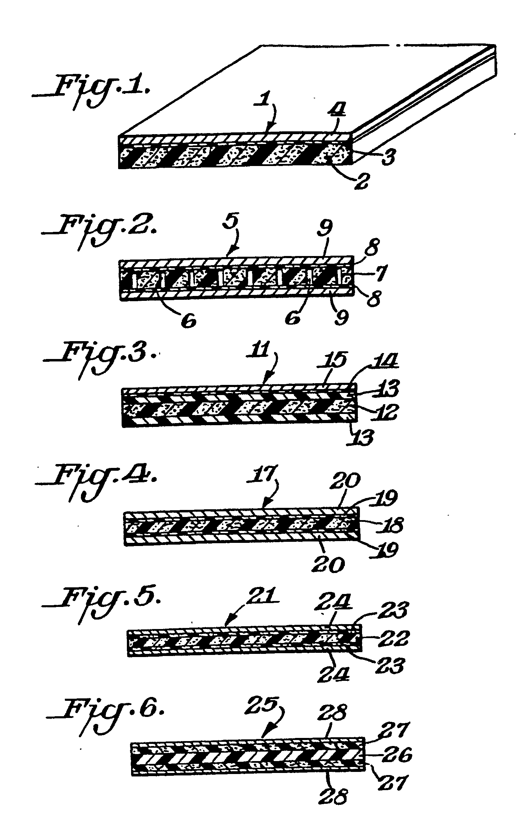

The present invention is best described in detail with reference to the embodiments shown in Figures 1-11.

In a printed circuit board 1 in the embodiment shown in Figure 1, a layer 4 of metal foil, such as copper foil or aluminum foil, is provided on the upper surface of a layer 2 of expanded, porous PTFE by means of layer 3 of a bonding agent consisting of tetrafluoroethylene-perfluoroalkyl-vinyl ether copolymer (PFA) or tetrafluoroethylene-fluoropropylene copolymer (FEP). The layer 4 of metal foil is then etched by conventional techniques to form a circuit pattern thereon, which is used as a conductor circuit. This conductor circuit may be formed by laminating a circuit pattern, which is formed separately in advance, on the layer 2 of expanded, porous PTFE with a bonding agent.

The layer 2 of expanded, porous PTFE may contain fillers. When a film which contains about 10% by weight of a metal oxide, for example titanium oxide or alumina, mixed therein, and which has been stretched not less than two times its original length is used as the layer 2, the thermal conductivity, bonding strength and dimensional stability thereof can be improved. Also, such a layer 2 has various effects referred to previously with reference to the present invention.

The layer thus obtained of expanded, porous PTFE can be formed into a layer 7 of the same resin provided with a plurality of through holes 6, as in the printed circuit board 5 shown in Figure 2. When this layer 7 is provided, the specific permittivity thereof further decreases, so that the overall properties of the printed circuit board can be further improved. In the embodiment shown in Figure 2, layers 9 of metal foil are provided on both surfaces of layer 7 of expanded, porous PTFE by means of layer 8 of a bonding agent.

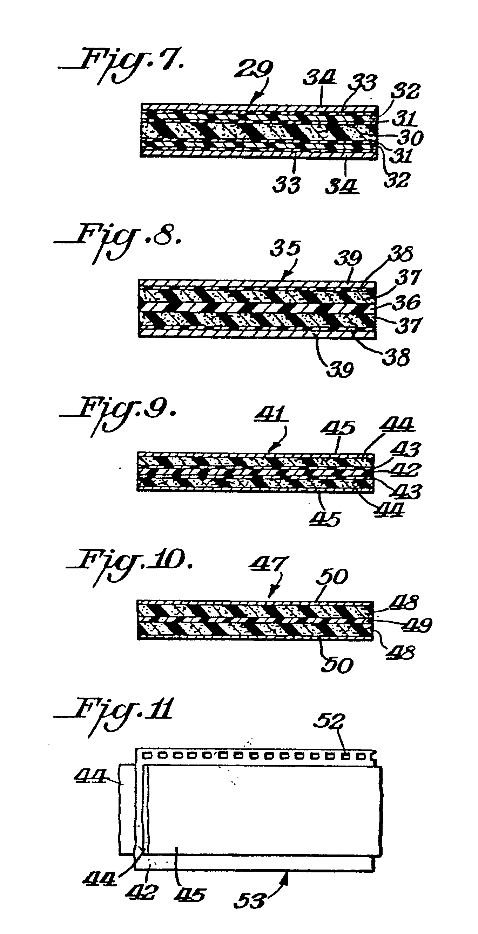

A printed circuit board 11 in the embodiment shown in Figure 3 is formed by providing layers 13 of solid PTFE on both sides of a layer 12 of expanded, porous PTFE by thermal fusion, and a layer 15 of metal foil is bonded to layer 13 of solid PTFE by means of layer 14 of a bonding agent. This layer 15 of metal foil is then subjected to an etching treatment, not shown, to form a conductor circuit thereon.

In a printed circuit board 17 in the embodiment shown in Figure 4, a cloth 18 made of fibers of expanded, porous PTFE is used as the layer of expanded, porous PTFE. Layers 20 of metal foil are provided on both sides of this cloth 18 by means of layer 19 of a bonding agent, and conductor circuits are then formed on the layers 20 by an etching treatment.

In a printed circuit board 21 shown in Figure 5, a layer of expanded, porous PTFE is formed by laminating layers 23 of expanded, porous PTFE of a relatively high specific gravity on to both surfaces of a layer 22 of expanded, porous PTFE, the specific gravity of which is smaller than that of the resin of layers 23, by thermal fusion. Layers 24 of a metal coating are formed on the outer surfaces of the layers 23 of the above-mentioned resin having a larger specific gravity by a conventional catalytic plating process, and these layers 24 are processed by an etching treatment to form electric circuits thereon. Thus, a printed circuit board having a layer of expanded, porous PTFE extending along the conductor circuits is provided.

Figure 6 shows a further alternative embodiment of the present invention. In a printed circuit board 25 in this embodiment, a hard core layer 26 is provided, which consists of a epoxy resin sheet or a metal plate or a combination thereof, so that the shape-retaining characteristics of the layers 27 of expanded, porous PTFE provided on both surfaces of the core 26 are improved. Layers 28 of an additive treatment plating catalyst containing a photo-sensitive titanium oxide as its main component are provided on the outer surfaces of the layers 27 of expanded, porous PTFE thus formed. The layers 28 of catalyst coating are subjected to a circuit pattern treatment, and then a surface treatment, as necessary, so that they can be plated smoothly. The resultant printed circuit board 25 is immersed in a plating liquid, such as a chemical copper plating liquid, to form conductor circuits on the outer surfaces thereof.

In a printed circuit board 29 in the embodiment shown in Figure 7, dimensionally stable films 32 of 10 micrometers in thickness consisting of a polyimide resin, a polyamide resin or a polyester resin are provided on both surfaces of layer 30 of 50 micrometers in thickness of expanded, porous PTFE by means of layers 31 of a bonding agent. Layers 34 of metal foil are provided on the outer surfaces of these dimensionally stable films 32 by means of layers 33 of a bonding agent. Conductor circuits are formed on the layers 34 of metal foil in the same manner as described above.

In a printed circuit board 35 in the embodiment shown in Figure 8, layers 37 of 50 micrometers in thickness of expanded, porous PTFE are provided on both sides of a central hard core layer 36, and bonding layers 38 of 5 micrometers in thickness consisting of a polyimide resin, a polyamide resin or a polyester resin on the outer surfaces of the layers 37. Layers 39 of metal foil are provided on the outer surface of the layers 38 by utilizing the same as layers of bonding agent. Conductor circuits are formed on these layers 39 in the same manner as described above.

In a printed circuit board 41 in the embodiment shown in Figure 9, layers 44 of 50 micrometers in thickness of expanded, porous PTFE are provided on both surfaces of a dimensionally stable film 42 of 10 micrometers in thickness by means of layers 43 of a bonding agent, and plating catalyst metallic layers 45 on the outer surfaces of the layers 44.

In a printed circuit board 47 in the embodiment shown in Figure 10, layer 49 of 5 micrometers in thickness of polyimide, polyamide or polyester resin is provided between two layers 48 of 10 micrometers in thickness of expanded, porous PTFE, and plating catalyst metallic layers 50 on the outer surfaces of the layers 48 of the mentioned resin. On the plating catalyst layers 45 and 50, conductor circuits are formed in the same manner as described before.

In the embodiments shown in Figures 7, 9 and 10, the printed circuit boards are provided with dimensionally stable films 32,42 or resin layer 49, so that the printed circuit boards are both firm enough and flexible enough. Therefore, these printed circuit boards can be manufactured and installed in a machine conveniently. When a printed circuit board 53, which is provided with film transferring carrier holes 52 as shown in Figure 11, is employed,the manufacturing cost and the circuit element mounting cost can be reduced, and the rationalization of the manufacture and use of the printed circuit boards can be done conveniently.

Shown in Figure 11 is a modified example of the embodiment of Figure 9, and the parts of the example, which are identical with those of the embodiment of Figure 9, are designated by the same reference numerals. In these embodiments, the printed circuit boards have a specific permittivity of not more than 3.0, dielectric loss of not more than 0.001 and a thermal expansion coefficient of around $3 \times 10^{-5}/^\circ$ C. Accordingly, the printed circuit boards can withstand the transmission of signals in a high-frequency region, and have suitable flexibility.

In the construction described above, in which a layer of stretched porous PTFE is provided along a conductor circuit to form a printed circuit board, the signal transmission delay time is very short, and the dielectric loss is small. Hence, a printed circuit board having a low signal attenuating rate can be obtained. Since a porous material is used, a printed circuit board having a low thermal expansion coefficient, an excellent cooling effect, high physical and chemical stability, and capability of connecting a dielectric line directly thereto can be obtained.

In the construction mentioned above, a dimensionally stable film of a polyimide resin, a polyamide resin or a polyester resin is provided bonded to and in laminar contact with a layer of expanded, porous PTFE. Therefore, the flexibility of the printed circuit board can be increased without greatly affecting the electric properties thereof. This enables the printed circuit board to be handled conveniently. Especially, when film carrier holes are provided in the printed circuit board, a film transferring operation can be employed using the film carrier system.

## Claims

1. A printed circuit board comprising a layer (2;7;12; 18;22,23;27;30;37;44;48) of polytetrafluoroethylene (PTFE) firmly bonded to and in laminar contact with at least one layer (4;9;15;20;24;34;39) of electrically conducting metal, characterised in that the PTFE layer is of expanded, porous PTFE.

2. A printed circuit board according to claim 1, wherein said metal layer (24) has been catalytically plated on to a surface of said expanded, porous PTFE layer (22,23).

3. A printed circuit board according to claim 1, wherein said metal layer (4;9;15;20;34;39) is a metal foil bonded to said expanded, porous PTFE layer (2;7;12;18;30;37) with a bonding agent (3;8;14;19;31;33;38).

4. A printed circuit board according to claim 3, wherein said bonding agent (3;8;14;19;31,33) consists of tetrafluoroethylene-perfluoroalkyl vinyl ether copolymer (PFA) or tetrafluoroethylene-hexafluoropropylene copolymer (FEP).

5. A printed circuit board according to any preceding claim, wherein said layer (18) of expanded, porous PTFE is a cloth woven from fibres of expanded, porous PTFE.

6. A printed circuit board according to any preceding claim, wherein said layer (2;7;12;18;22,23;27;30;37;44; 48) of expanded porous PTFE contains a filler.

7. A printed circuit board according to claim 6, wherein said filler is titanium dioxide powder.

8. A printed circuit board according to claim 6, wherein sid filler is aluminum oxide powder.

9. A printed circuit board according to any preceding claim, wherein said layer (7) of expanded, porous PTFE has a plurality of through holes (6).

10. A printed circuit board according to any preceding claim, wherein said layer of expanded, porous PTFE is a composite of a plurality of layers (22,23) of expanded, porous PTFE having different specific gravities.

11. A printed circuit board according to any preceding claim, wherein said expanded, porous PTFE has a layer (13;26;32;36;38;42;49) of solid, non-porous plastic material bonded to one side thereof.

12. A printed circuit board according to claim 11, wherein said solid layer (13;32;38;42;49) consists of solid, non-porous PTFE, polyimide resin, polyamide resin or polyester resin.

**Revendications**

1. Plaquette de circuit imprimé comprenant une couche (2 ; 7 ; 12 ; 18 ; 22, 23 ; 27 ; 30 ; 37 ; 44 ; 48) de polytétrafluoroéthylène (PTFE) fermement liée et en contact lamellaire avec au moins une couche (4 ; 9 ; 15 ; 20 ; 24 ; 34 ; 39) de métal électriquement conducteur, caractérisée en ce que la couche de PTFE est constituée par du PTFE expansé poreux.

2. Plaquette de circuit imprimé selon la revendication 1, dans laquelle ladite couche métallique (24) a été plaquée par voie catalytique sur une surface de ladite couche de PTFE expansé poreux (22, 23).

3. Plaquette de circuit imprimé selon la revendication 1, dans laquelle ladite couche métallique (4 ; 9 ; 15 ; 20 ; 34 ; 39) est une feuille métallique liée à ladite couche de PTFE expansé poreux (2 ; 7 ; 12 ; 18 ; 30 ; 37) avec un adhésif (3 ; 8 ; 14 ; 19 ; 31 ; 33 ; 38).

4. Plaquette de circuit imprimé selon la revendication 3, dans laquelle ledit adhésif (3 ; 8 ; 14 ; 19 ; 31 ; 33) consiste en un copolymère tétrafluoroéthylène-perfluoroalkyl-vinyléther (PFA) ou en un copolymère tétrafluoroéthylène-hexafluoropropylène (FEP).

5. Plaquette de circuit imprimé selon l'une quelconque des revendications précédentes, dans laquelle ladite couche (18) de PTFE expansé poreux est un tissu de fibres de PTFE expansé poreux.

6. Plaquette de circuit imprimé selon l'une quelconque des revendications précédentes, dans laquelle ladite couche (2 ; 7 ; 12 ; 18 ; 22, 23 ; 27 ; 30 ; 37 ; 44 ; 48) de PTFE expansé poreux contient une charge.

7. Plaquette de circuit imprimé selon la revendication 6, dans laquelle ladite charge est une poudre de dioxyde de titane.

8. Plaquette de circuit imprimé selon la revendication 6, dans laquelle ladite charge est une poudre d'oxyde d'aluminium.

9. Plaquette de circuit imprimé selon l'une quelconque des revendications précédentes, dans laquelle ladite couche (7) de PTFE expansé poreux comporte une pluralité de trous traversants (6).

10. Plaquette de circuit imprimé selon l'une quelconque des revendications précédentes, dans laquelle ladite couche de PTFE expansé poreux est un composite d'une pluralité de couches (22, 23) de PTFE expansé poreux de masses volumiques différentes.

11. Plaquette de circuit imprimé selon l'une quelconque des revendications précédentes, dans laquelle une couche (13 ; 26 ; 32 ; 36 ; 38 ; 42 ; 49) de matière plastique compacte non poreuse est liée à un côté dudit PTFE expansé poreux.

12. Plaquette de circuit imprimé selon la revendication 11, dans laquelle ladite couche compacte (13 ; 32 ; 38 ; 42 ; 49) consiste en PTFE compact non poreux, en résine de polyimide, en résine de polyamide ou en résine de polyester.

## Ansprüche

1. Gedruckte Leiterplatte, umfassend eine Schicht (2; 7; 12; 18; 22, 23; 27; 30; 37; 44; 48) aus Polytetrafluoräthylen (PTFE), die fest gebunden ist an und in lamellenförmigem Kontakt steht mit mindestens einer Schicht (4; 9; 15; 20; 24; 34; 39) aus elektrisch leitendem Material,
dadurch **gekennzeichnet,**
daß die PTFE-Schicht expandiertes, poröses PTFE ist.

2. Leiterplatte nach Anspruch 1, bei der die Metallschicht (24) auf einer Fläche der Schicht (22, 23) aus expandiertem, porösen PTFE katalytisch aufplattiert ist.

3. Leiterplatte nach Anspruch 1, bei der die Metallschicht (4; 9; 15; 20; 34; 39) eine Metallfolie ist, die mit einem Bindemittel (3; 8; 14; 19; 31; 33; 38) auf die Schicht (2; 7; 12; 18; 30; 37) aus expandiertem, porösen PTFE aufgeklebt ist.

4. Leiterplatte nach Anspruch 3, bei der das Bindemittel (3; 8; 14; 19; 31, 33) besteht aus Tetrafluoräthylen-Perfluoralkyl-Vinyl-Äther-Copolymer (PFA) oder Tetrafluoräthylen-Hexafluorpropylen-Copolymer (FEP).

5. Leiterplatte nach irgendeinem vorhergehenden Anspruch, bei der die Schicht (18) aus expandiertem, porösen PTFE ein aus Fasern aus expandiertem, porösen PTFE gewobener Stoff ist.

6. Leiterplatte nach irgendeinem vorhergehenden Anspruch, bei der die Schicht (2; 7; 12; 18; 22, 23; 27; 30; 37; 44; 48) aus expandiertem, porösen PTFE einen Füllstoff enthält.

7. Leiterplatte nach Anspruch 6, bei der der Füllstoff Titandioxid-Pulver ist.

8. Leiterplatte nach Anspruch 6, bei der der Füllstoff Aluminiumoxid-Pulver ist.

9. Leiterplatte nach irgendeinem vorhergehenden Anspruch, bei der die Schicht (7) aus expandiertem, porösen PTFE mehrere Durchgangslöcher (6) aufweist.

10. Leiterplatte nach irgendeinem vorhergehenden Anspruch, bei der die Schicht aus expandiertem, porösen PTFE ein Verbund aus mehreren Schichten (22, 23) aus expandiertem, porösen PTFE mit verschiedenen spezifischen Gewichten ist.

11. Leiterplatte nach irgendeinem vorhergehenden Anspruch, bei der das expandierte, poröse PTFE eine Schicht (13; 26; 32; 36; 38; 42; 49) aus massivem, nicht-porösen Kunststoff an ihrer einen Seite angeklebt hat.

12. Leiterplatte nach Anspruch 11, bei der die massive Schicht (13; 32; 38; 42; 49) aus massivem, nicht-porösen PTFE, Polyimidharz, Polyamidharz oder Polyesterharz besteht.

Fig.1.

Fig.2.

Fig.3.

Fig.4.

Fig.5.

Fig.6.

Fig.7.

Fig.8.

Fig.9.

Fig.10.

Fig.11